# EUROPEAN PATENT SPECIFICATION

(11) **EP 2 503 699 B1**
(45) Date of publication and mention of the grant of the patent: **19.06.2013**
(21) Application number: 11159070.9
(22) Date of filing: 21.03.2011
(51) Int. Cl.: H04B 1/04, H04B 1/52

(54) **Electronic device with VCO pulling compensation circuit for an input baseband signal and associated methods**
Elektronische Vorrichtung mit VCO-Verstimmungsausgleichsschaltung für ein Basisbandeingangssignal und zugehörige Verfahren
Dispositif électronique avec circuit de compensation de tirage OTA pour signal de bande de base d'entrée et procédés associés

(43) Date of publication of application: 26.09.2012
(73) Proprietor: Research In Motion Limited, Waterloo, ON N2L 3W8 (CA)
(72) Inventor: Manku, Tajinder, Waterloo Ontario N2L 3W8 (CA)
(74) Representative: Hibbert, Juliet Jane Grace

(56) References cited:
- US-A1- 2005 186 918
- US-A1- 2006 202 767
- US-B2- 7 808 325

## Description

### Technical Field

The present disclosure relates to the field of electronic devices, and, more particularly, electronic devices with VCO pulling compensation circuits.

### Background

Wireless communication technology, which has become a fundamental part of modern communications infrastructures, is evolving at an ever growing pace in order to meet the demanding performance characteristics of new mobile wireless communication devices. It is desired that these new mobile wireless communications devices are able to transmit data with a minimum about of signal distortion.

A typical modulation and power amplification circuit, such as used in the transmitter of known mobile wireless communications devices, includes a mixer coupled between an input signal and a power amplifier. This mixer mixes the input signal with an output signal from a voltage controlled oscillator (VCO), and outputs the combined signal to the power amplifier for wireless transmission.

One cause of transmit signal distortion is known as "pulling," which is undesired coupling between components of the mobile wireless communications device. One particularly undesirable form of pulling is coupling between the transmitter and the VCO. This coupling can cause the frequency of the signal output by the VCO to be "pulled" low, and may also cause distortion in the signal output by the VCO. Since the mixer combines the input signal with the signal output by the VCO, an improper frequency of the signal output by the VCO, or distortion in the signal output by the VCO may result in undesirable distortion of the resulting transmit signal.

One example of coupling between the transmitter and the VCO is where harmonics from additional components of the modulation and power amplification circuit, such as a pre-power amplifier, couple to the VCO at the package or chip level. Another example is that of harmonics present at input/output lines of the power amplifier being coupled to the VCO, also at the package or chip level. In yet another example, coupling between the power amplifier and VCO can occur within a shielding cavity surrounding the transmitter.

Since such coupling or "pulling" results in distortion of the transmitted signal, new transmitter designs that mitigate these effects are desired. US 2006/0202767 discloses a method comprising injecting an injection pulling compensation signal into the voltage controlled oscillator.

### Brief Description of the Drawings

FIG. 1 a schematic block diagram of a mobile wireless communications device in accordance with the present disclosure.

FIG. 2 is a flowchart of a method of making the mobile wireless communications device of FIG. 1.

FIG. 3 is a schematic block diagram illustrating example components of a mobile wireless communications device that may include the components shown in FIG. 1.

### Detailed Description

The present description is made with reference to the accompanying drawings, in which various embodiments are shown. However, many different embodiments may be used, and thus the description should not be construed as limited to the embodiments set forth herein. Rather, these embodiments are provided so that this disclosure will be thorough and complete. Like numbers refer to like elements throughout, and prime notation is used to indicate similar elements or steps in alternative embodiments.

Generally speaking, an electronic device may include a transmitter comprising a baseband input for at least one baseband signal, at least one mixer downstream from the baseband input, and a phase-locked loop (PLL). The PLL may comprise a voltage controlled oscillator (VCO) and a phase detector coupled thereto, and the VCO may be coupled to the at least one mixer. At least one power amplifier may be downstream from the at least one mixer, and may generate at least one aggressing signal that would otherwise generate an output pull of the VCO, thereby causing transmit distortion on a transmit signal. A receiver may be coupled to the at least one power amplifier and may comprise a sense input configured to receive the transmit signal. A VCO pulling compensation circuit may be coupled to the baseband input and may be configured to compensate the at least one baseband signal for the transmit distortion based upon the sensed transmit signal.

The VCO may operate at a multiple of a desired frequency of the transmit signal. In addition, the VCO pulling compensation circuit may include an exponential block configured to raise the transmit signal to an exponent equal to the multiple of the desired frequency

The VCO pulling compensation circuit may further comprises a filter coupled to the exponential block configured to determine the transmit distortion by determining distortion present in the exponential of the received transmit signal. The VCO pulling compensation circuit may further comprise a mixer having a first mixer input coupled to the filter, an adder having an adder output coupled to a second mixer input of the mixer, and a first adder input coupled to a mixer output of the mixer.

The VCO pulling compensation circuit may further comprise an emulated transmitter gain block having an input coupled to the baseband input to receive the baseband signal and an output coupled to a second adder input of the adder. The VCO pulling compensation circuit may also further comprise an additional adder having inputs coupled to the mixer output and the baseband input, and an output coupled to the transmitter.

The electronic device may include an adder having an input coupled to the output of the emulated transmitter gain block, and an output coupled to another input of the emulated transmitter gain block and an input of the filter. The PLL may further comprise a fractional divider coupled between an output of the VCO and the phase detector, and a low-pass filter coupled between the phase detector and the VCO.

A method aspect may be directed to a method of making an electronic device comprising forming a transmitter by coupling at least one mixer downstream from a baseband input for at least one baseband signal, and coupling a voltage controlled oscillator (VCO) to a phase detector, and coupling the VCO to the at least one mixer, to thereby form a phase-locked loop (PLL). At least one power amplifier may be coupled downstream from the at least one mixer, the at least one power amplifier generating at least one aggressing signal that would otherwise generate an output pull of the VCO, thereby causing transmit distortion on a transmit signal.

The method may also include coupling a receiver to the at least one power amplifier, the receiver comprising a sense input configured to receive the transmit signal. The method may further comprise coupling a VCO pulling compensation circuit to the baseband input, and configuring the VCO pulling compensation circuit to compensate the at least one baseband signal for the transmit distortion based upon the sensed transmit signal.

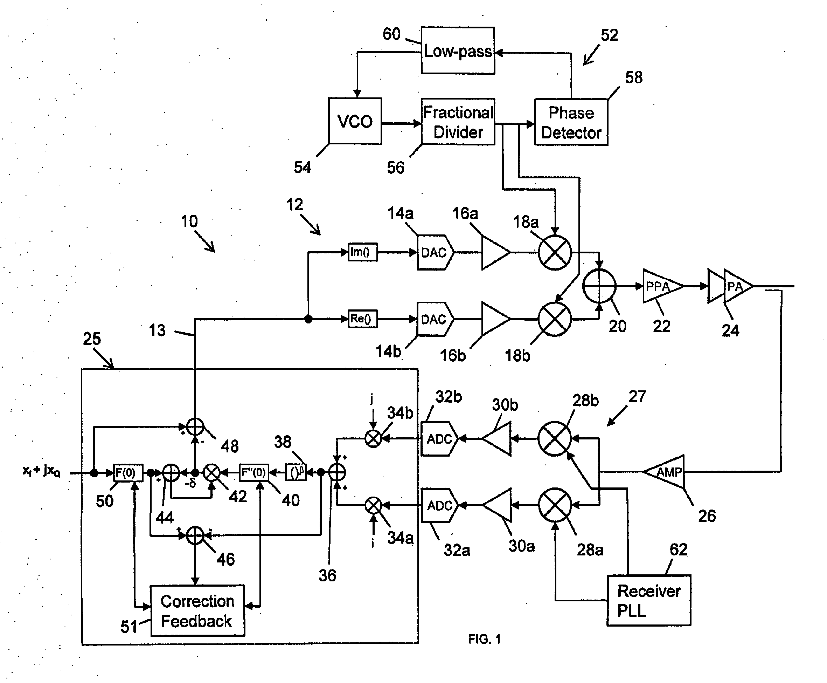

With initial reference to FIG. 1, an electronic device **10** is now described. The electronic device **10** may be a mobile wireless communications device. Example mobile wireless communications devices may include portable or personal media players (e.g., music or MP3 players, video players, etc.), remote controls (e.g., television or stereo remotes, etc.), portable gaming devices, portable or mobile telephones, smartphones, tablet computers, etc.

The electronic device **10** includes a transmitter **12**. The transmitter may any suitable digital transmitter, and operate in any suitable frequency band, and should not be construed as being limited to the components shown. The transmitter **12** illustratively includes a baseband input **13** for at least one baseband signal. The at least one baseband signal includes the in-phase (I) and quadrature (Q) transmit signals. The baseband input **13** is coupled to a pair of digital to analog converters (DAC) **14a, 14b.** A respective amplifier **16a, 16b** is coupled to each DAC **14a, 14b**. The electronic device **10** also includes two mixers **18a, 18b** respectively coupled to the DACs **18a, 18b.** The mixers **14a**, **14b** may each be an up-converting mixer, for example.

The electronic device **10** also includes a phase-locked loop (PLL) **52** configured to a desired transmit channel. The PLL illustratively includes a voltage controlled oscillator (VCO) **54** coupled to each of the mixers **18a, 18b** so that they are driven to a desired transmit channel, for example. The PLL also illustratively includes a fractional divider **56** coupled to an output of the VCO **54**, a phase/frequency detector (PFD) **58** coupled to the fractional divider, and a loop filter or low pass filter **60** coupled to an output of the fractional divider. The PFD **56** produces a positive voltage which may increase the output frequency when the VCO output is lower than the desired output frequency and vice versa. This may be done by comparing the VCO divided output from the fractional divider **56** to a frequency reference signal F_{ref} and producing a control voltage (error signal) that is filtered by the low pass filter **60** to remove noise. The PFD **56** generates a voltage signal that is generally proportional to the difference between the reference frequency and the frequency at the output of the fractional divider **56**. The control voltage may regulate the voltage control of the VCO **54** to drive the error signal to zero, for example.

The characteristics of the VCO **54** are such that both the input and the power supply of the VCO changes the output frequency. A typical cross coupled LC tank based low phase noise VCO provides input control that selects the center frequency and bias control that selects the tail current. The transfer function from the voltage input of the VCO **54** to the output frequency is governed by Kvco/s where K_{VCO} determines the change in output frequency per Volt of change in the input signal. The transfer function from the power supply (not shown) is similar and managed by a different value Kₚᵤₛₕ, which generally determines the change in the output frequency with the change in the supply voltage V_{DD}. This concept is widely known as supply pushing.

The electronic device **20** also includes a power pre-amplifier (PPA) **22** and a power amplifier (PA) **24** downstream from the two mixers **18a, 18b**. The outputs from the two mixers **18a, 18b** is summed at the summer **20** before being input to the power pre-amplifier **22**. The output from the power pre-amplifier **22** is input to the power amplifier **24**. The power amplifier **24** may typically provide 2 Watts of output power to a radiating antenna (not shown). As will be appreciated by those skilled in the art, the output of the power amplifier **24** may include modulation data around a carrier frequency, whereas an oscillator driving the mixer(s) may be a continuous wave (CW) signal at the carrier frequency in a direct conversion transmitter. In some embodiments, the power pre-amplifier **22** may not be included or additional pre and/or power amplifiers and/or power amplifier drivers may be used.

The power amplifier **24** generates an aggressing signal that would otherwise generate an output pull of the VCO **54.** The aggressing signal can be interpreted in several ways. One way is to recognize that the amplitude modulation of the signal at the output of the power amplifier **24** bounces the ground that is shared by the VCO **34.**

As will be appreciated by those skilled in the art, VCO pulling increasingly affects operation of components within the electronic device **10,** and thus may negatively affect communications performance. This is generally due to the VCO frequency output feeding into the up-conversion mixers **18a, 18b** that, in turn, feed the input of the power pre-amplifier **22**, and, thus, creates a closed loop. Particular attention to power supply design and isolation of the power amplifier from other circuitry, for example, may reduce the effect on the communications performance.

When an aggressing signal is brought closer to the VCO **54**, it pulls the VCO output frequency to follow the aggressing signal. There are several mechanisms described in literature that create the pulling of the VCO **54**. The VCO **54** is generally a nonlinear circuit, and thus, it may down convert the aggressing signal and produce a down converted aggressing signal that modulates the input of the VCO over and beyond the control voltage forced by the PLL. This may cause an undesired disturbance for the PLL that it tries to counteract. However, while the PLL reacts, the output of the VCO **54** follows the aggressing signal and may cause exceeding of an emission spectrum at the output of the power amplifier **24**, for example.

The aggressing signal moves the power and ground. On the supply side (V_{DD}), a decoupling capacitor (not shown) placed directly on the supply of the VCO **54** may be used to help protect against the aggressing signal. A capacitor may not provide adequate protection due to the inductance of the wires that connect the supply of the VCO **54** to the power, however.

Moreover, there may be a physical size limitation to the amount of decoupling capacitors that may be placed within a limited space on an integrated circuit, for example, that includes the VCO **54** and power pre-amplifier **22**. Coupling capacitors external to the integrated circuit (IC) including the components of the electronic device **10** typically do not help address this problem because bond wires are inductive and provide significant impedance at the RF carrier frequencies. Hence, the VCO **54** may have limited protection by the decoupling capacitor and by the PLL itself. As will be appreciated by those skilled in the art, typically, the board layout should be such as to reduce the inductance and resistance from the supply of the VCO **54** to external power. It is highly desirable that the ground seen by the VCO **54** is as close to a ground seen by the power amplifier **24** as possible. To address this, grounding layers on the IC level, package substrate level, and PCB level are increased, while very short traces are used to extend from the IC, for example, to the power amplifier **24.** This becomes increasingly difficult when considering multi-mode, multi-band radios that use several power amplifiers and external components. The power amplifiers may also have to be electromagnetically shielded by placing them in individual metal enclosures or cans that occupy limited board space on small form-factor phones, for example.

To avoid the time consuming approach of multiple board revisions of an electronic device and the chip substrate improving isolation step by step, the current disclosure includes an approaches to address this problem by predistorting the baseband signal so as to cancel out the distortion to the transmit signal resulting from the VCO pulling.

To address the VCO pulling caused by the aggressing signal, the electronic device **10** includes a VCO pulling compensation circuit **25** coupled to the input and a receiver **27.** The receiver includes an amplifier **26** coupled to the power amplifier **24** which receives the signal transmitted thereby. A pair of mixers **28a, 28b** are coupled to the amplifier **26**. A receiver PLL **62** is coupled to the mixers **28a, 28b**. The mixers **28a, 28b** are in turn coupled to amplifiers **30a, 30b**, which are in turn coupled to analog to digital converters (ADCs) **32a, 32b**. The ADCs **32a, 32b** are coupled to mixers **34a, 34b**, the outputs of which are summed by the summer **36**.

The VCO pulling compensation circuit **25** is configured to compensate the at least one baseband signal for the transmit distortion caused by aggressing signal and the resulting VCO pulling, based upon a sensed transmit signal.

It should be appreciated that the VCO **54** operated at a multiple of a desired frequency of the transmit signal. For example, if the desired transmit frequency is X, the VCO may be operated at 2X, 4X, 8X, etc. The summer **36** is coupled to an exponential block **38**, which is configured to raise the transmit signal to an exponent equal to the multiple of the desired frequency. This is performed so as to allow inspection of the harmonics of the transmit signal, which are where particularly troublesome distortion often occurs. For example, if the VCO 54 is operating at 2X, the VCO pulling results from the aggressing signal is at 3BB assuming the transmit signal xi and xj were signal tones inputted at a frequency of BB. Similarly, if the VCO **54** is operating at 4X, the pulling tone is at -5BB, and the corresponding distortion tone is at 5BB. Further, if the VCO **54** is operating at 8X, the pulling tone is at 9BB, and the corresponding distortion tone is at -9BB.

The exponential block **38** is coupled to a filter **40**. The filter **40** is configured to determine the transmit distortion by determining distortion present in the harmonics of the received transmit signal, and is made to emulate the response of the TX PLL from the input of the VCO to it's output, for example.

The filter **40** is coupled to a first input of a mixer **42**. An output of a summer **44** is coupled to the second input of the mixer **42**, and the output of the mixer is in turn coupled to a first input of the summer **44**. An output of an emulated transmitter gain block **50** is coupled to the second input of the summer **44**. The emulated transmitter gain block **50** accepts the at least the baseband signal and amplifies it by a gain and a phase rotation. The second input of the summer **44** and the output of the summer **36** are coupled to the inputs of a summer **46,** the output of which is coupled to a correction feedback block **51.** The correction feedback block **51** determines the difference between the received transmit signal and the at least one baseband signal, and outputs correction values to the emulated transmitter gain block 50 and filter **40**. For example, it sends corrected gain and phase rotation values to the emulated transmitter gain block **50**, and filter tap values to the filter **40**.

The output of the mixer **42**, as well as the at least one baseband signal, are coupled to an adder **48**. The output of the adder **48** represents the input **13** to the transmitter **12**.

Through the mixer **42**, and summers **44, 48** the inverse of the distortion as determined by the filter **40** and the exponential block **38** is added to the at least one baseband signal on the input **13**. This pre-distortion is then canceled out by the distortion caused by the VCO pulling, and the resulting transmit signal is clean.

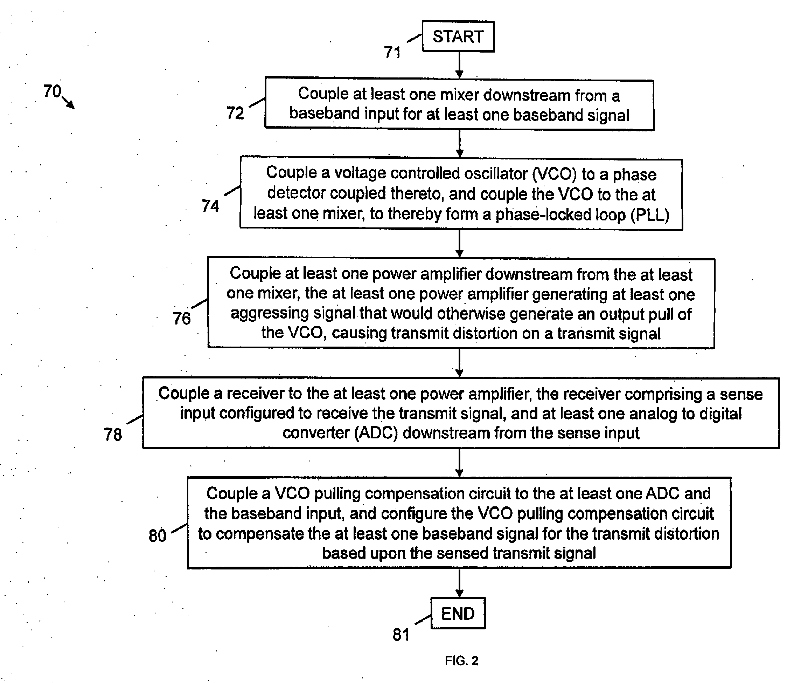

With reference to the flowchart **70** of FIG. 2, a method of making a mobile wireless communications device is now described. After the start (Block **71**), at least one mixer is coupled downstream from a baseband input for at least one baseband signal (Block **72**).

Then a voltage controlled oscillator (VCO) is coupled to a phase detector, and the VCO is coupled to the at least one mixer, to thereby form a phase-locked loop (PLL) (Block **74**). Thereafter, at least one power amplifier is coupled downstream from the at least one mixer, the at least one power amplifier generating at least one aggressing signal that would otherwise generate an output pull of the VCO, causing transmit distortion on a transmit signal (Block **76**).

Next, a receiver is coupled to the at least one power amplifier, the receiver comprising a sense input configured to receive the transmit signal, and at least one analog to digital converter (ADC) downstream from the sense input (Block **78**). Furthermore, a VCO pulling compensation circuit is coupled to the at least one ADC and the baseband input, and the VCO pulling compensation circuit is configured to compensate the at least one baseband signal for the transmit distortion based upon the sensed transmit signal (Block **80**). Block **81** indicates the end of the method.

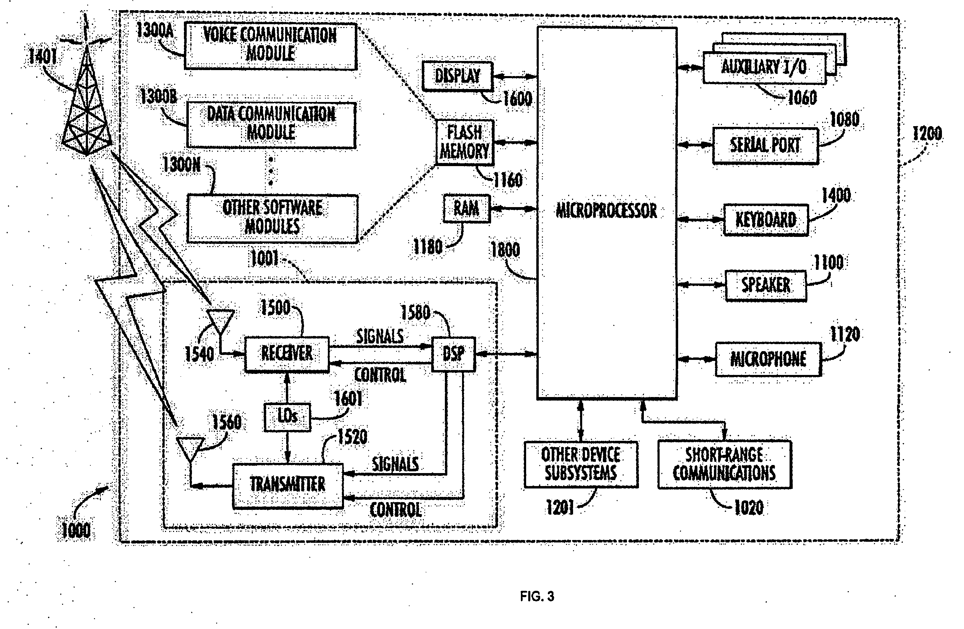

Example components of a mobile wireless communications device **1000** that may be used in accordance with the above-described embodiments are further described below with reference to FIG. 3. The device **1000** illustratively includes a housing **1200**, a keyboard or keypad **1400** and an output device **1600**. The output device shown is a display **1600,** which may comprise a full graphic LCD. Other types of output devices may alternatively be utilized. A processing device **1800** is contained within the housing **1200** and is coupled between the keypad **1400** and the display **1600**. The processing device **1800** controls the operation of the display **1600**, as well as the overall operation of the mobile device **1000**, in response to actuation of keys on the keypad **1400.**

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 3. These include a communications subsystem **1001**; a short-range communications subsystem **1020**; the keypad **1400** and the display **1600**, along with other input/output devices **1060**, **1080**, **1100** and **1120**; as well as memory devices **1160**, **1180** and various other device subsystems **1201**. The mobile device **1000** may comprise a two-way RF communications device having data and, optionally, voice communications capabilities. In addition, the mobile device **1000** may have the capability to communicate with other computer systems via the Internet.

Operating system software executed by the processing device **1800** is stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180**. Communications signals received by the mobile device may also be stored in the RAM **1180.**

The processing device **1800**, in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401.** The PIM data items may be seamlessly integrated, synchronized and updated via the wireless network **1401** with corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex™, Data TAC™ or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3GPP, UMTS, 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore typically involves use of a subscriber identity module, commonly referred to as a SIM card, in order to operate on a GPRS network.

When required network registration or activation procedures have been completed, the mobile device **1000** may send and receive communications signals over the communication network **1401**. Signals received from the communications network **1401** by the antenna **1540** are routed to the receiver **1500**, which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520**. For example, gains applied to communications signals in the receiver **1500** and transmitter **1520** may be adaptively controlled through automatic gain control algorithms implemented in the DSP **1580**.

In a data communications mode, a received signal, such as a text message or web page download, is processed by the communications subsystem **1001** and is input to the processing device **1800**. The received signal is then further processed by the processing device **1800** for an output to the display **1600**, or alternatively to some other auxiliary I/O device **1060**. A device may also be used to compose data items, such as e-mail messages, using the keypad **1400** and/or some other auxiliary I/O device **1060**, such as a touchpad, a rocker switch, a thumb-wheel, or some other type of input device. The composed data items may then be transmitted over the communications network **1401** via the communications subsystem **1001**.

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. An electronic device **(10)** comprising:
a transmitter **(12)** comprising
a baseband input **(13)** for at least one baseband signal,
at least one mixer **(18a, 18b)** downstream from said baseband input,
a phase-locked loop (PLL) **(52)** comprising a voltage controlled oscillator (VCO) **(54)** and a phase detector **(58)** coupled thereto, said VCO coupled to said at least one mixer,
at least one power amplifier **(24)** downstream from said at least one mixer, generating at least one aggressing signal that would otherwise generate an output pull of said VCO, causing transmit distortion on a transmit signal,
a receiver coupled **(27)** to said at least one power amplifier and comprising a sense input configured to receive the transmit signal;
a VCO pulling compensation circuit **(25)** coupled to said baseband input and configured to compensate the at least one baseband signal for the transmit distortion based upon the sensed transmit signal.

2. The electronic device **(10)** of Claim 1,
wherein said VCO **(54)** operates at a multiple of a desired frequency of the transmit signal; and wherein said VCO pulling compensation **(25)** circuit comprises an exponential block **(38)** configured to raise the transmit signal to an exponent equal to the multiple of the desired frequency.

3. The electronic device **(10)** of Claim 2,
wherein said VCO pulling compensation circuit **(25)** further comprises a filter **(40)** coupled to said exponential block **(38)** configured to determine the transmit distortion by determining distortion present in the exponential of the received transmit signal.

4. The electronic device **(10)** of Claim 3,
wherein said VCO pulling compensation circuit **(25)** further comprises
a mixer **(42)** having a first mixer input coupled to said filter **(40),**
an adder **(44)** having an adder output coupled to a second mixer input of said mixer, and a first adder input coupled to a mixer output of said mixer.

5. The electronic device **(10)** of Claim 4,
wherein said VCO pulling compensation circuit **(25)** further comprises an emulated transmitter gain block **(50)** having an input coupled to the baseband input to receive the baseband signal and an output coupled to a second adder input of said adder **(44).**

6. The electronic device **(10)** of Claim 5,
wherein said VCO pulling compensation circuit **(25)** further comprises an additional adder **(48)** having inputs **(13)** coupled to the mixer output and the baseband input, and an output coupled to said transmitter **(12)**.

7. The electronic device **(10)** of Claim 6, further comprising an adder **(46)** having an input coupled to the output of the emulated transmitter gain block **(50)**, and an output coupled to another input of the emulated transmitter gain block and an input of the filter **(40).**

8. The electronic device **(10)** of Claim 1,
wherein said PLL **(52)** further comprises a fractional divider **(56)** coupled between an output of said VCO **(54)** and said phase detector **(58)**, and a low-pass filter **(60)** coupled between said phase detector and said VCO.

9. A method of making an electronic device (10) comprising:
forming a transmitter **(12)** by
coupling at least one mixer **(18a, 18b)** downstream from a baseband input **(13)** for at least one baseband signal,
coupling a voltage controlled oscillator (VCO) **(54)** to a phase detector **(58),** and coupling the VCO to the at least one mixer, to thereby form a phase-locked loop (PLL) **(54),** and
coupling at least one power amplifier **(24)** downstream from the at least one mixer, the at least one power amplifier generating at least one aggressing signal that would otherwise generate an output pull of the VCO, causing transmit distortion on a transmit signal **(27)**;
coupling a receiver to the at least one power amplifier, the receiver comprising a sense input configured to receive the transmit signal; and
coupling a VCO pulling compensation circuit **(25)** to the baseband input, and configuring the VCO pulling compensation circuit to compensate the at least one baseband signal for the transmit distortion based upon the sensed transmit signal **(80)**.

10. The method of Claim 9, wherein the VCO **(54)** operates at a multiple of a desired frequency of the transmit signal; and wherein the VCO pulling compensation circuit **(25)** comprises an exponential block **(38)** configured to raise the transmit signal to an exponent equal to the multiple of the desired frequency.

11. The method of Claim 10, wherein the VCO pulling compensation circuit **(25)** further comprises a filter **(40)** coupled to the exponential block **(38)** configured to determine the transmit distortion by determining distortion present in the exponential of the received transmit signal.

12. The method of Claim 11, wherein the VCO pulling compensation circuit **(25)** further comprises
a mixer **(42)** having a first mixer input coupled to the filter **(40),**
an adder **(44)** having an adder output coupled to a second mixer input of the mixer, and a first adder input coupled to a mixer output of the mixer.

13. The method of Claim 12, wherein the VCO pulling compensation circuit **(25)** further comprises an emulated transmitter gain block **(50)** having an input coupled to the baseband input to receive the baseband signal and an output coupled to a second adder input of the adder **(44)**.

14. The method of Claim 13, wherein the VCO pulling compensation circuit **(25)** further comprises an additional adder **(48)** having inputs coupled to the mixer output and the baseband input, and an output coupled to the transmitter **(12).**

15. The method of Claim 14, further comprising coupling an input of an adder **(46)** to the output of the emulated transmitter gain block **(50),** and coupling an output of the adder to another input of the emulated transmitter gain block and an input of the filter **(40).**

## Patentansprüche

1. Elektronische Vorrichtung (10), die aufweist:
einen Sender (12), der aufweist
einen Basisband-Eingang (13) für zumindest ein Basisband-Signal, zumindest einen Mischer (18a, 18b) stromabwärts von dem Basisband-Eingang,
einen Phasenregelkreis (PLL - phase-locked loop) (52), der einen spannungsgesteuerten Oszillator (VCO-voltage controlled oscillator) (54) und einen damit gekoppelten Phasendetektor (58) aufweist, wobei der VCO mit dem zumindest einen Mischer gekoppelt ist, zumindest einen Leistungsverstärker (24) stromabwärts von dem zumindest einen Mischer zum Erzeugen zumindest eines angreifenden Signals, das ansonsten ein Ausgangs-Pull des VCOs erzeugen würde, was eine Sendeverzerrung auf einem Sendesignal verursacht,
einen Empfänger (27), der mit dem zumindest einen Leistungsverstärker gekoppelt ist und einen Erfassungs-Eingang aufweist, der konfiguriert ist zum Empfangen des Sendesignals;
eine VCO-Pull-Kompensationsschaltung (25), die mit dem Basisband-Eingang gekoppelt ist und konfiguriert ist, das zumindest eine Basisband-Signal für die Sendeverzerrung basierend auf dem erfassten Sendesignal zu kompensieren.

2. Die elektronische Vorrichtung (10) gemäß Anspruch 1, wobei der VCO (54) an einem Vielfachen einer gewünschten Frequenz des Sendesignals arbeitet; und wobei die VCO-Pull-Kompensationsschaltung (25) einen Exponentialblock (38) aufweist, der konfiguriert ist zum Erhöhen des Sendesignals auf einen Exponent, der gleich dem Vielfachen der gewünschten Frequenz ist.

3. Die elektronische Vorrichtung (10) gemäß Anspruch 2, wobei die VCO-Pull-Kompensationsschaltung (25) weiter einen Filter (40) aufweist, der mit dem Exponentialblock (38) gekoppelt ist, der konfiguriert ist zum Bestimmen der Sendeverzerrung durch Bestimmen einer Verzerrung, die in dem Exponential des empfangenen Sendesignals vorhanden ist.

4. Die elektronische Vorrichtung (10) gemäß Anspruch 3, wobei die VCO-Pull-Kompensationsschaltung (25) weiter aufweist
einen Mischer (42) mit einem ersten Mischer-Eingang, der mit dem Filter (40) gekoppelt ist,
einen Addierer (44) mit einem Addierer-Ausgang, der mit einem zweiten Mischer-Eingang des Mischers gekoppelt ist, und einem ersten Addierer-Eingang, der mit einem Mischer-Ausgang des Mischers gekoppelt ist.

5. Die elektronische Vorrichtung (10) gemäß Anspruch 4, wobei die VCO-Pull-Kompensationsschaltung (25) weiter aufweist einen emulierten Senderverstärkungsblock (50) mit einem Eingang, der mit dem Basisband-Eingang gekoppelt ist, um das Basisband-Signal zu empfangen, und einem Ausgang, der mit einem zweiten Addierer-Eingang des Addierers (44) gekoppelt ist.

6. Die elektronische Vorrichtung (10) gemäß Anspruch 5, wobei die VCO-Pull-Kompensationsschaltung (25) weiter aufweist einen zusätzlichen Addierer (48) mit Eingängen (13), die mit dem Mischer-Ausgang und dem Basisband-Eingang gekoppelt sind, und einem Ausgang, der mit dem Sender (12) gekoppelt ist.

7. Die elektronische Vorrichtung (10) gemäß Anspruch 6, die weiter aufweist einen Addierer (46) mit einem Eingang, der mit dem Ausgang des emulierten Senderverstärkungsblocks (50) gekoppelt ist, und einem Ausgang, der mit einem anderen Eingang des emulierten Senderverstärkungsblocks und einem Eingang des Filters (40) gekoppelt ist.

8. Die elektronische Vorrichtung (10) gemäß Anspruch 1, wobei der PLL (52) weiter einen Teiler (56) aufweist, der zwischen einem Ausgang des VCOs (54) und dem Phasendetektor (58) gekoppelt ist, und einen Tiefpaßfilter (60), der zwischen dem Phasendetektor und dem VCO gekoppelt ist.

9. Ein Verfahren zur Herstellung einer elektronischen Vorrichtung (10), das aufweist:
Bilden eines Senders (12) durch
Koppeln zumindest eines Mischers (18a, 18b) stromabwärts von einem Basisband-Eingang (13) für zumindest ein Basisband-Signal, Koppeln eines spannungsgesteuerten Oszillators (VCO - voltage controlled oscillator) (54) mit einem Phasendetektor (58) und Koppeln des VCOs mit dem zumindest einen Mischer, um dadurch einen Phasenregelkreis (PLL - phase-locked loop) (54) zu bilden, und Koppeln zumindest eines Leistungsverstärkers (24) stromabwärts von dem zumindest einen Mischer, wobei der zumindest eine Leistungsverstärker zumindest ein angreifendes Signal erzeugt, das ansonsten ein Ausgangs-Pull des VCOs erzeugen würde, was eine Sendeverzerrung auf einem Sendesignal (27) verursacht;
Koppeln eines Empfängers mit dem zumindest einen Leistungsverstärker,
wobei der Empfänger einen Erfassungs-Eingang aufweist, der konfiguriert ist zum Empfangen des Sendesignals; und
Koppeln einer VCO-Pull-Kompensationsschaltung (25) mit dem Basisband-Eingang und Konfigurieren der VCO-Pull-Kompensationsschaltung, das zumindest eine Basisband-Signal für die Sendeverzerrung basierend auf dem erfassten Sendesignal (80) zu kompensieren.

10. Das Verfahren gemäß Anspruch 9, wobei der VCO (54) an einem Vielfachen einer gewünschten Frequenz des Sendesignals arbeitet; und wobei die VCO-Pull-Kompensationsschaltung (25) einen Exponentialblock (38) aufweist, der konfiguriert ist zum Erhöhen des Sendesignals auf einen Exponent, der gleich dem Vielfachen der gewünschten Frequenz ist.

11. Das Verfahren gemäß Anspruch 10, wobei die VCO-Pull-Kompensationsschaltung (25) weiter einen Filter (40) aufweist, der mit dem Exponentialblock (38) gekoppelt ist, der konfiguriert ist zum Bestimmen der Sendeverzerrung durch Bestimmen einer Verzerrung, die in dem Exponential des empfangenen Sendesignals vorhanden ist.

12. Das Verfahren gemäß Anspruch 11, wobei die VCO-Pull-Kompensationsschaltung (25) weiter aufweist
einen Mischer (42) mit einem ersten Mischer-Eingang, der mit dem Filter (40) gekoppelt ist,
einen Addierer (44) mit einem Addierer-Ausgang, der mit einem zweiten Mischer-Eingang des Mischers gekoppelt ist, und einem ersten Addierer-Eingang, der mit einem Mischer-Ausgang des Mischers gekoppelt ist.

13. Das Verfahren gemäß Anspruch 12, wobei die VCO-Pull-Kompensationsschaltung (25) weiter aufweist einen emulierten Senderverstärkungsblock (50) mit einem Eingang, der mit dem Basisband-Eingang gekoppelt ist, um das Basisband-Signal zu empfangen, und einem Ausgang, der mit einem zweiten Addierer-Eingang des Addierers (44) gekoppelt ist.

14. Das Verfahren gemäß Anspruch 13, wobei die VCO-Pull-Kompensationsschaltung (25) weiter aufweist einen zusätzlichen Addierer (48) mit Eingängen, die mit dem Mischer-Ausgang und dem Basisband-Eingang gekoppelt sind, und einem Ausgang, der mit dem Sender (12) gekoppelt ist.

15. Das Verfahren gemäß Anspruch 14, das weiter aufweist ein Koppeln eines Eingangs eines Addierers (46) mit dem Ausgang des emulierten Senderverstärkungsblocks (50) und ein Koppeln eines Ausgangs des Addierers mit einem anderen Eingang des emulierten Senderverstärkungsblocks und einem Eingang des Filters (40).

## Revendications

1. Dispositif électronique (10) comprenant :
un émetteur (12) comprenant
une entrée de bande de base (13) pour au moins un signal de bande de base ;
au moins un mélangeur (18a, 18b) en aval de ladite entrée de bande de base,
une boucle à verrouillage de phase (PLL) (52) comprenant un oscillateur commandé en tension (VCO) (54) et un détecteur de phase (58) qui lui est relié, ledit VCO étant relié audit au moins un mélangeur,
au moins un amplificateur de puissance (24) en aval dudit au moins un mélangeur, générant au moins un signal perturbateur qui génèrerait par ailleurs un appel de sortie dudit VCO, provoquant une distorsion d'émission sur un signal d'émission,
un récepteur (27) relié audit au moins un amplificateur de puissance et comprenant une entrée de lecture configurée pour recevoir le signal d'émission ;
un circuit de compensation d'appel de VCO (25) relié à ladite entrée de bande de base et configuré pour compenser la distorsion d'émission de l'au moins un signal de bande de base sur la base du signal d'émission détecté.

2. Dispositif électronique (10) selon la revendication 1, dans lequel ledit VCO (54) fonctionne à un multiple d'une fréquence souhaitée du signal s'émission ; et dans lequel ledit circuit de compensation de VCO (25) comprend un bloc exponentiel (38) configuré pour élever le signal d'émission à une puissance égale au multiple de la fréquence souhaitée.

3. Dispositif électronique (10) selon la revendication 2, dans lequel ledit circuit de compensation d'appel de VCO (22) comprend en outre un filtre (40) relié audit bloc exponentiel (38) configuré pour déterminer la distorsion d'émission en déterminant la distorsion présente dans l'exposant du signal d'émission reçu.

4. Dispositif électronique (10) selon la revendication 3, dans lequel ledit circuit de compensation d'appel de VCO (25) comprend en outre
un mélangeur (42) ayant une première entrée de mélangeur reliée audit filtre (40),
un additionneur (44) ayant une sortie d'additionneur reliée à une seconde entrée de mélangeur dudit mélangeur, et une première entrée d'additionneur reliée à une sortie de mélangeur dudit mélangeur.

5. Dispositif électronique (10) selon la revendication 4, dans lequel ledit circuit de compensation d'appel de VCO (25) comprend en outre un bloc de gain d'émetteur émulé (50) ayant une entrée reliée à l'entrée de bande de base pour recevoir le signal de bande de base et une sortie reliée à une seconde entrée d'additionneur dudit additionneur (44).

6. Dispositif électronique (10) selon la revendication 5, dans lequel ledit circuit de compensation d'appel de VCO (25) comprend en outre un additionneur supplémentaire (48) ayant des entrées (13) reliées à la sortie de mélangeur et à l'entrée de bande de base, et une sortie reliée audit émetteur (12).

7. Dispositif électronique (10) selon la revendication 6, comprenant en outre un additionneur (46) ayant une entrée reliée à la sortie du bloc de gain d'émetteur émulé (50) et une sortie reliée à une autre entrée du bloc de gain d'émetteur émulé et à une entrée du filtre (40).

8. Dispositif électronique (10) selon la revendication 1, dans lequel ladite boucle PLL (52) comprend en outre un diviseur fractionnaire (56) relié entre une sortie dudit VCO (54) et ledit détecteur de phase (58), et un filtre passe-bas (60) relié entre ledit détecteur de phase et ledit VCO.

9. Procédé de réalisation d'un dispositif électronique (10) consistant à :
former un émetteur (12)
en reliant au moins un mélangeur (18a, 18b) en aval de ladite entrée de bande de base (13) destinée à au moins un signal de bande de base,
en reliant un oscillateur commandé en tension (VCO) (54) à un détecteur de phase (58) et en reliant le VCO à l'au moins un mélangeur pour ainsi former une boucle à verrouillage de phase (PLL) (54), et
en reliant au moins un amplificateur de puissance (24) en aval de l'au moins un mélangeur, l'au moins un amplificateur de puissance générant au moins un signal perturbateur qui génèrerait par ailleurs un appel de sortie dudit VCO en provoquant une distorsion d'émission sur un signal d'émission (27) ;
relier un récepteur à l'au moins un amplificateur de puissance, le récepteur comprenant une entrée de détection configurée pour recevoir le signal d'émission ; et
relier un circuit de compensation d'appel de VCO (24) à l'entrée de bande de base et configurer le circuit de compensation d'appel de VCO afin de compenser la distorsion d'émission de l'au moins un signal de bande de base sur la base du signal d'émission détecté (80).

10. Procédé selon la revendication 9, dans lequel ledit VCO (54) fonctionne à un multiple d'une fréquence souhaitée du signal d'émission ; et dans lequel le circuit de compensation d'appel de VCO (25) comprend un bloc exponentiel (38) configuré pour élever le signal d'émission à une puissance égale au multiple de la fréquence souhaitée.

11. Procédé selon la revendication 10, dans lequel le circuit de compensation d'appel de VCO (25) comprend en outre un filtre (40) relié au bloc exponentiel (38), configuré pour déterminer la distorsion d'émission en déterminant la distorsion présente dans l'exposant du signal d'émission reçu.

12. Procédé selon la revendication 11, dans lequel ledit circuit de compensation d'appel de VCO (25) comprend en outre
un mélangeur (42) ayant une première entrée de mélangeur reliée au filtre (40),
un additionneur (44) ayant une sortie d'additionneur reliée à une seconde entrée de mélangeur du mélangeur, et une première entrée d'additionneur reliée à une sortie de mélangeur du mélangeur.

13. Procédé selon la revendication 12, dans lequel le circuit de compensation d'appel de VCO (25) comprend en outre un bloc de gain d'émetteur émulé (50) ayant une entrée reliée à l'entrée de bande de base pour recevoir le signal de bande de base et une sortie reliée à une seconde entrée d'additionneur de l'additionneur (44).

14. Procédé selon la revendication 13, dans lequel le circuit de compensation d'appel de VCO (25) comprend en outre un additionneur supplémentaire (48) ayant des entrées reliées à la sortie de mélangeur et à l'entrée de bande de base, et une sortie reliée à l'émetteur (12).

15. Procédé selon la revendication 14, consistant en outre à relier une entrée d'un additionneur (46) à la sortie du bloc de gain d'émetteur émulé (50), et à relier une sortie de l'additionneur à une autre entrée du bloc de gain d'émetteur émulé et à une entrée du filtre (40).
